# FASCICULE DE BREVET EUROPEEN

(11) **EP 3 642 635 B1**
(45) Date de publication et mention de la délivrance du brevet: **17.05.2023**
(21) Numéro de dépôt: 18735194.5
(22) Date de dépôt: 14.06.2018
(51) Int. Cl.: G01R 15/18, G01R 33/04

(54) **CAPTEUR DE COURANT A CIRCULATION DE CHAMP MAGNETIQUE**
STROMSENSOR MIT MAGNETFELDZIRKULATION
CURRENT SENSOR WITH MAGNETIC FIELD CIRCULATION

(30) Priorité: 23.06.2017 FR 1755775
(43) Date de publication de la demande: 29.04.2020
(73) Titulaire: Neelogy, 37550 Saint-Avertin (FR)
(72) Inventeur: CIMA, Lionel, Fabien, 37540 Saint-Cyr-sur-Loire (FR)
(74) Mandataire: Gevers & Orès
(86) Numéro de dépôt international: PCT/EP2018/065750
(87) Numéro de publication internationale: WO 2018/234133

(56) Documents cités:
- EP-A1- 2 009 453
- EP-A2- 2 084 720
- FR-A1- 2 931 945
- FR-A1- 2 971 852
- JP-A- H11 295 348
- JP-A- 2002 333 455
- "IEEE Guide for the Application of Rogowski Coils Used for Protective Relaying Purposes;IEEE Std C37.235-2007 ED - Anonymous", IEEE STANDARD; [IEEE STANDARD], IEEE, PISCATAWAY, NJ, USA, 22 février 2008 (2008-02-22), pages c1-45, XP017604093, ISBN: 978-0-7381-5713-9
- ERIC VOURC'H ET AL: "Neel Effect Toroidal Current Sensor", IEEE TRANSACTIONS ON MAGNETICS, IEEE SERVICE CENTER, NEW YORK, NY, US, vol. 49, no. 1, 1 janvier 2013 (2013-01-01), pages 81-84, XP011483180, ISSN: 0018-9464, DOI: 10.1109/TMAG.2012.2222021
- E. Vourc'h ET AL: "ANALYTICAL AND NUMERICAL ANALYSES OF A CURRENT SENSOR USING NON LINEAR EFFECTS IN A FLEXIBLE MAGNETIC TRANSDUCER", Progress In Electromagnetics Research, Vol. 99, 31 décembre 2009 (2009-12-31), pages 323-338, XP055009208, http://www.jpier.org/PIER/index.php DOI: 10.2528/PIER09102006 Extrait de l'Internet: URL:http://www.jpier.org/PIER/pier99/20.09 102006.pdf [extrait le 2011-10-11]

## Description

La présente invention se rapporte à un dispositif de mesure de champ magnétique et plus particulièrement de mesure de courants continus et/ou alternatifs circulant dans un conducteur primaire. Le domaine de l'invention est celui de la mesure des champs magnétiques comme les magnétomètres ou de la mesure de courants électriques par l'intermédiaire de leurs champs magnétiques comme les transducteurs de courant sans contact.

On connaît des capteurs de courant tels que les capteurs de courant de type Rogowski qui déterminent la valeur d'un courant traversant un conducteur primaire à partir de la circulation d'un champ magnétique généré par ledit courant. Les capteurs de type Rogowski utilisent des transducteurs encore appelés sondes Rogowski. De tels transducteurs comprennent généralement une bobine allongée s'étendant autour d'un noyau souple allongé constitué d'un matériau amagnétique. Le transducteur Rogowski est alors associé à un circuit électronique qui détermine à partir des grandeurs électriques mesurées aux bornes de la bobine la valeur du flux magnétique circulant à l'intérieur de ladite bobine pour en déduire, lorsque la bobine entoure un conducteur électrique, l'intensité du courant circulant dans le conducteur électrique. Les transducteurs Rogowski sont particulièrement performants pour réaliser des mesures de courants alternatifs au-delà d'une certaine fréquence de coupure. Toutefois, ils présentent l'inconvénient d'être inopérant pour la mesure de courants continus.

Pour la mesure de courants continus, il existe une technologie dite à Effet Néel^{®}. On appelle Effet Néel^{®} la technologie décrite dans la demande de brevet FR2891917. La technologie à effet Néel^{®} repose sur l'utilisation d'un transducteur formé d'un bobinage entourant un composite magnétique sans rémanence B(H), dont la dérivée troisième à l'origine présente un extremum. Le composant magnétique est par exemple un composite superparamagnétique. La technologie à Effet Néel^{®} est peu sensible aux champs extérieurs du fait de la faible perméabilité du matériau magnétique utilisé. Les transducteurs à Effet Néel^{®} existent sous une forme «universelle » flexible particulièrement adaptée pour mesurer les courants continus par exemple tel que décrit dans la demande de brevet FR2931945. La topologie présentée dans la demande de brevet FR2931945 présente une forte immunité à la diaphonie en mettant en oeuvre pratiquement la théorie du théorème d'ampère, i.e. en faisant une mesure de circulation du champ magnétique sur un contour extérieur sensiblement fermé.

Il est également possible de combiner un capteur à Effet Néel^{®} et un capteur de type Rogowski classique pour réaliser un capteur « passe-tout » de large bande passante incluant le courant continu.

De manière générale, le procédé de fabrication de capteurs bobinés flexibles repose sur la réalisation d'un câble transducteur de grande longueur. Le câble est ensuite coupé à la bonne longueur pour constituer un transducteur avec deux extrémités. Afin de constituer une boucle, qui peut être éventuellement « ouvrante », les deux extrémités sont reliées par un mécanisme de fermeture.

L'un des défauts de la mesure de courant basée sur la circulation de champ magnétique à l'aide de capteurs bobinés est dû à la présence d'un écartement entre les deux extrémités du bobinage au niveau du mécanisme de fermeture. Cet écartement introduit notamment trois types d'erreur dans la mesure de courant :
- une erreur de gain au niveau de la mesure du courant dans le conducteur primaire, qui dépend de la position du conducteur primaire par rapport au mécanisme de fermeture ;
- une erreur due à la sensibilité du capteur aux champs magnétiques extérieurs ;
- une erreur due à la sensibilité du capteur aux courants des conducteurs voisins.

A chaque fois, cette erreur tient au fait que la circulation du champ magnétique dans la bobine ne s'effectue pas sur un chemin fermé. Autrement dit, cette erreur est proportionnelle à la circulation du champ magnétique qui est non mesurée dans l'écartement.

Il existe différentes techniques connues pour réduire cette erreur liée à l'écartement.

Par exemple, il est classique d'utiliser un bobinage secondaire supplémentaire que l'on place au niveau de l'écartement et dont la fonction est de compléter la mesure de circulation de champ avec une estimation de la circulation dans l'écartement. Cette technique est notamment décrite dans la demande de brevet EP2887076. Cette solution simple présente toutefois quelques inconvénients :
- elle nécessite une opération industrielle supplémentaire dans sa réalisation, voire un composant supplémentaire ;
- elle ne corrige pas complètement les erreurs de gain ou de diaphonie lorsque les conducteurs sont très proches de l'écartement ;
- elle ne fonctionne pas en courant continu.

Une autre solution classique est l'utilisation d'un noyau magnétique placé dans l'écartement et permettant de réduire la réluctance de cet écartement. Ainsi, d'un point de vue magnétique, l'écartement est réduit considérablement par l'effet de perméabilité du noyau magnétique. Une telle solution est décrite par exemple dans la demande de brevet EP2009453 et présente les inconvénients suivants :
- elle nécessite une opération industrielle supplémentaire dans sa réalisation, voire un composant supplémentaire ;
- elle ne corrige pas complètement les erreurs de gain ou de diaphonie lorsque les conducteurs primaires sont très proches de l'écartement ;
- elle rajoute des erreurs de non linéarité dues au noyau ferromagnétique.

Par ailleurs, la demande de brevet français publiée sous le numéro FR 2 971 852 A1, la demande de brevet européen publiée sous le numéro EP 2 009 453 A1 et la demande de brevet japonais JP 2002 333455 A décrivent chacun un mécanisme de fermeture de bobine.

Il est donc apparu le besoin d'un nouveau type de mécanisme de fermeture qui soit tout à la fois plus performant et adaptable à la mesure de courants alternatifs et de courants continus.

On atteint au moins l'un des objectifs précités avec un capteur d'un courant circulant dans un conducteur primaire, selon la revendication 1. Des caractéristiques optionnelles de l'invention sont énoncées dans les revendications 2 à 14.

Le capteur selon l'invention est avantageusement simple à réaliser. Il est par ailleurs apte à fournir une mesure de courant précise. Un autre avantage du capteur selon l'invention est qu'il peut s'adapter facilement pour réaliser une mesure de courant continu, une mesure de courant alternatif ou encore l'une ou l'autre de ces mesures à l'aide du même capteur.

D'autres avantages et caractéristiques de l'invention apparaîtront à l'examen de la description détaillée de plusieurs modes de réalisation nullement limitatifs, et des dessins annexés, sur lesquels :
- La figure 1 est une vue schématique d'un capteur de courant selon l'invention présentant plus particulièrement l'écartement entre les extrémités de bobines ;
- La figure 2 est une vue de dessus d'un mécanisme de fermeture du capteur selon l'invention ;
- La figure 3 est une vue en perspective du mécanisme de fermeture du capteur selon l'invention ;
- La figure 4 est une représentation schématique d'un exemple de capteur selon l'invention à quatre bobines.

Les modes de réalisation qui seront décrits dans la suite ne sont nullement limitatifs ; on pourra notamment mettre en oeuvre des variantes de l'invention ne comprenant qu'une sélection de caractéristiques décrites par la suite, isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont prévus pour être combinés entre eux dans toutes les combinaisons où rien ne s'y oppose sur le plan technique.

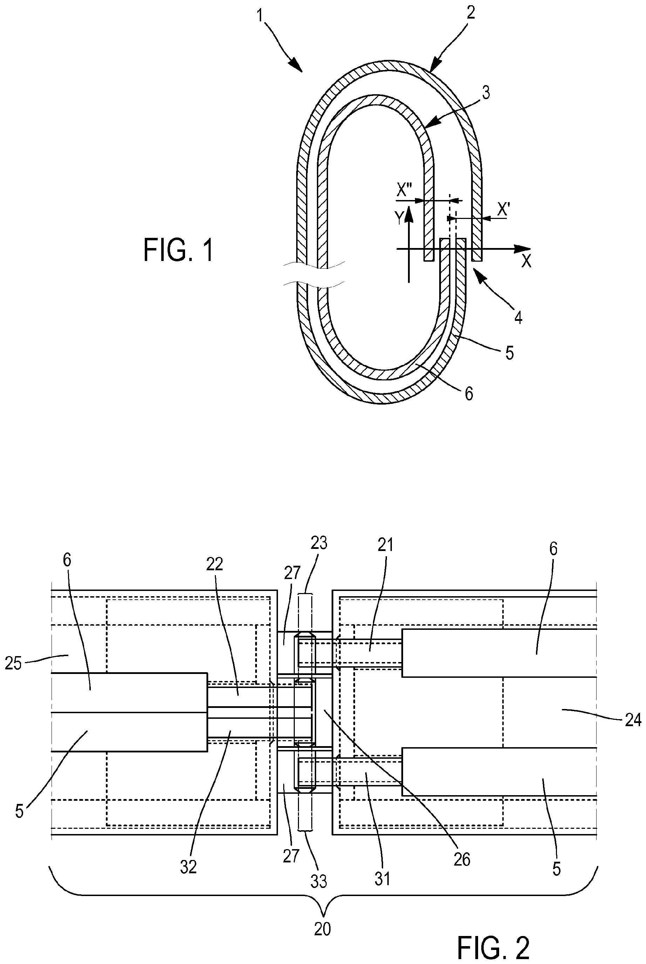

La figure 1 présente un capteur de courant 1 selon l'invention. Le capteur de courant mesure un courant circulant dans un conducteur primaire non représenté, entouré par le capteur de courant 1. Le principe exploité par le capteur de courant 1 est basé sur une mesure d'un champ magnétique généré par le courant circulant dans le conducteur primaire.

Le capteur de courant 1 selon l'invention est composé d'au moins deux transducteurs magnétiques 2, 3. Chaque transducteur magnétique 2, 3 peut être composé d'une ou plusieurs bobines 5, 6 par exemple en cuivre. Les bobines 5, 6 sont allongées et s'enroulent autour d'un support souple. Sur la figure 1, le capteur 1 comprend deux transducteurs 2, 3 et chaque transducteur 2, 3 comprend une seule bobine 5, 6. Chaque transducteur est relié de manière conventionnelle à un circuit électronique, non représenté, chargé de réaliser la mesure.

Les transducteurs 2, 3 peuvent être assemblés de façon concentrique autour du conducteur primaire. Les transducteurs peuvent par exemple être situés sensiblement dans un même plan transversal par rapport au conducteur primaire. Sur la figure 1 et dans la suite de l'exposé, le nombre de transducteur est un nombre pair.

Chaque transducteur forme une boucle ouverte autour du conducteur primaire. Les bobines 5, 6 composant chaque transducteur formant la boucle ouverte, forment au moins une ouverture 4 dans le transducteur, ladite ouverture 4 coïncidant pour l'ensemble des transducteurs. Selon l'invention, deux extrémités de bobines 5, 6 d'un même transducteur se chevauchent au niveau de l'ouverture 4, de sorte à fermer la boucle. Le chevauchement des extrémités des bobines 5, 6 d'un même transducteur 2, 3 forme un désaxage de ces extrémités l'une par rapport à l'autre.

La distance entre les deux extrémités de bobines 5, 6 d'un même transducteur 2, 3 s'exprime comme un écartement mécanique négatif ou nul ou encore inférieur ou égal à zéro, selon un axe d'élongation Y des bobines. Par exemple l'écartement mécanique peut être défini par rapport à un premier axe Y sensiblement tangent aux extrémités des bobines 5, 6. Le fait d'utiliser un écartement mécanique négatif ou nul dans la direction de l'axe d'élongation Y des bobines 5, 6 permet d'estimer avec une très grande précision la circulation du champ magnétique sur un chemin, formé par les bobines 5, 6, et fermé dans la direction de l'axe Y d'élongation des bobines 5, 6. Le fait d'avoir un écartement mécanique négatif permet donc de compenser les effets liés aux bords des bobines 5, 6. La longueur de l'écartement mécanique peut être inférieure à cinq fois le diamètre moyen d'une spire de bobinage d'une bobine, voire inférieur à deux fois le diamètre d'une spire d bobinage, voire une fois, voire la moitié, voire le quart ou bien nul. De manière générale, la longueur de l'écartement mécanique dépend notamment du diamètre du bobinage, du nombre de couches de spires dans le bobinage, etc ....

Le désaxage entre les deux extrémités d'une même boucle peut se mesurer selon un deuxième axe de désaxage X différent du premier axe Y. Par exemple le deuxième axe de désaxage X peut être sensiblement perpendiculaire au premier axe d'élongation Y. On appelle écartement de désaxage l'écartement entre les deux extrémités de bobines 5, 6 d'un même transducteur 2, 3 selon l'axe de désaxage X. Ainsi le désaxage du premier transducteur 2 est un désaxage négatif X" selon la direction de l'axe X et le désaxage du deuxième transducteur 3 est un désaxage positif X' selon la direction de l'axe X. L'écartement de désaxage X', X" entre deux extrémités d'une même boucle, ou d'un même transducteur 2, 3, doit être sensiblement égal à l'écartement de désaxage entre deux extrémités d'une autre boucle, ou transducteur 2, 3 du capteur 1 selon l'invention.

Les écartements de désaxage de chaque transducteur sont réalisés dans des sens opposés selon l'axe de désaxage X afin d'annuler les erreurs de mesure liées à la présence de la discontinuité des bobines 5, 6, par différence entre les deux grandeurs de champ électromagnétiques mesurées. Autrement dit le désaxage du premier transducteur 2 est le symétrique du désaxage du deuxième transducteur 3 par rapport à un plan de symétrie passant par le premier axe d'élongation Y et sensiblement perpendiculaire au plan des transducteurs. Ainsi tel que représenté sur la figure 1, deux extrémités, dont une de chaque bobine 5, 6 des deux transducteurs 2, 3, sont positionnées de part et d'autre des deux autres extrémités de chaque bobine 5, 6 des deux transducteurs 2, 3. On dit alors qu'il y a une inversion mécanique des désaxages entre les deux transducteurs 2, 3. Avantageusement, l'inversion mécanique des désaxages entre les deux transducteurs 2, 3 permet de réaliser une mesure différentielle pour éliminer les impacts des champs magnétiques orthogonaux généré par le conducteur primaire au niveau des extrémités des bobines 5, 6. En effet, l'erreur de mesure introduite par le désaxage des extrémités des bobines 5, 6 est proportionnelle aux champs magnétiques orthogonaux au premier axe d'élongation Y des bobinages et à la grandeur X'-X". Ainsi si X'=X", la totalité des erreurs peut être éliminée.

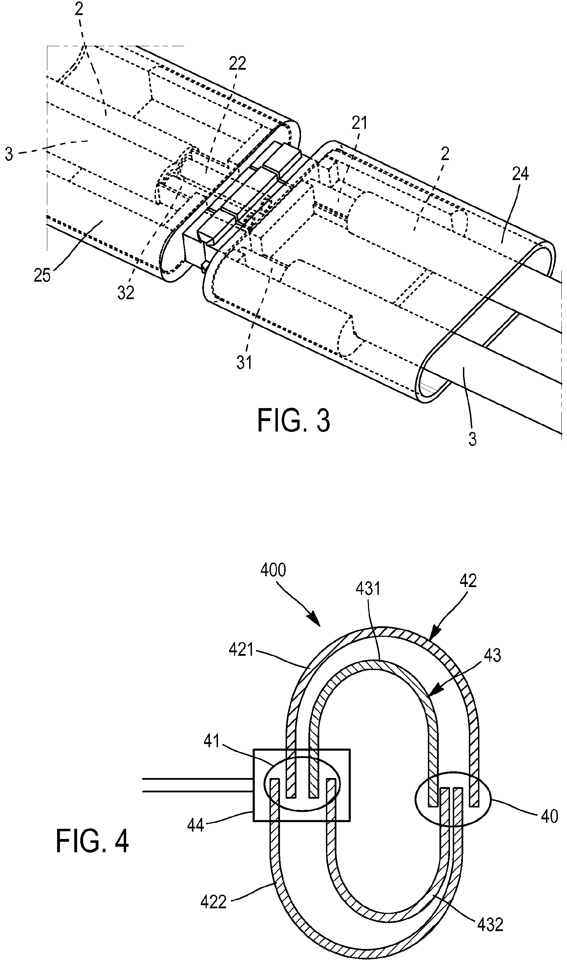

La figure 2 représente une vue de dessus d'un mécanisme de fermeture 20 des boucles des transducteurs 2, 3 selon l'invention. La figure 3 représente le même mécanisme de fermeture 20 en perspective. Les figures 2 et 3 reprennent les références de la figure 1 pour les objets préalablement décrits. Sur les figures 2 et 3 on peut notamment voir les deux extrémités 21, 22, 31, 32 des bobines 5, 6 de chaque transducteur 2, 3. Ainsi la première extrémité 21 de la première bobine 6 se trouve à l'extérieur dans le mécanisme de fermeture 20, alors que la deuxième extrémité 22 de la première bobine 6 se trouve à l'intérieur dans le mécanisme de fermeture 20. La première extrémité 32 de la deuxième bobine 5 se trouve à proximité de la deuxième extrémité 22 de la première bobine 6 à l'intérieur, dans le mécanisme de fermeture 20. Et la deuxième extrémité 31 de la deuxième bobine 5 se trouve à l'extérieure dans le mécanisme de fermeture 20. On comprend la notion « intérieur dans le mécanisme de fermeture » une position à proximité d'un centre du mécanisme de fermeture 20. On comprend la notion « extérieure dans le mécanisme de fermeture », comme étant à proximité de l'enveloppe extérieure du mécanisme de fermeture 20 tout en étant à l'intérieur du mécanisme de fermeture 20.

Le mécanisme de fermeture 20 comprend deux parties 24, 25 entourant chacune une extrémité de bobine 5, 6 d'un des transducteurs 2, 3. Le mécanisme de fermeture peut être réalisé au moyen d'un boîtier en plastique ou en résine collé autour des extrémités des bobines 5, 6 ou bien surmoulé autour desdites extrémités des bobines 5, 6.

Les deux parties 24, 25 sont agencées pour s'enficher l'une dans l'autre afin de réaliser la fermeture des boucles des transducteurs 2, 3, tout en assurant :
- un écartement longitudinal mécanique négatif 23, 33 entre les deux extrémités de bobines fermant chaque boucle de transducteur 2, 3 et,
- un désaxage latéral de chaque extrémité par rapport à l'autre extrémité de bobine 5, 6 fermant un même transducteur 2, 3.

Avantageusement, le mécanisme de fermeture 2 peut être dit réversible dans le sens où il autorise plusieurs fermetures et ouvertures des boucles des transducteurs 2, 3 par exemple pour permettre audit capteur de se positionner autour du conducteur primaire, puis retirer ledit capteur. A cette fin, le mécanisme de fermeture 20 peut comporter un système de fixation réversible comportant deux parties 26, 27 chacune solidaire d'une des parties du mécanisme de fermeture 24, 25, lesdites parties 26, 27 du système de fixation réversible étant aptes à être fixées ou non fixées entre elles. Par exemple le système de fixation réversible peut comprendre des épingles et crochets, des vis et trous taraudés, des clips, etc ....

Le capteur 1 tel que représenté sur les figures 1, 2, 3 peut être un capteur 1 utilisant des transducteurs 2, 3 aptes à mesurer un courant continu ou un courant alternatif ou les deux. Ainsi, le capteur 1 peut comprendre, exclusivement ou non, des transducteurs à Effet Néel^{®} particulièrement adaptés à une mesure de courant continu. Le capteur 1 peut en outre comprendre, exclusivement ou non, des transducteurs à enroulement de Rogowski particulièrement adaptés à la mesure de courants alternatifs.

Un transducteur à Effet Néel^{®} comprend un support allongé réalisé sous la forme d'un noyau magnétique souple allongé sensiblement plein. Le noyau magnétique est constitué par un matériau magnétique souple comprenant une matrice souple ou flexible dans laquelle sont dispersées des particules magnétiques.

Dans une variante du capteur selon l'invention, représentée sur la figure 4, un capteur 400 comprend deux transducteurs 42, 43 composés chacun de deux bobines respectivement 421, 422, et 431, 432, montées deux à deux pour former un boucle de transducteur 42, 43. Le capteur 400 présente ainsi deux ouvertures 40, 41 pouvant faire l'objet chacune d'un mécanisme de fermeture 20 tel que précédemment présenté. Avantageusement, l'une des ouvertures 41 peut être utilisée pour une connexion des transducteurs à une électronique 44 du capteur 400 apte à transmettre et à prendre en compte les mesures réalisées par les transducteurs 42, 43 afin de calculer le courant circulant dans un conducteur primaire, non représenté, entouré par le capteur 400. Les quatre bobines 421, 431, 422, 432 peuvent être agencées pour réaliser une mesure à l'aide de l'Effet Néel^{®} ou bien une mesure de Rogowski.

Dans une autre variante dérivée de la Figure 1 et non représentée, les bobines peuvent être utilisées de la manière suivante : au moins quatre bobines peuvent être utilisées pour réaliser un transducteur à Effet Néel@ en leur associant deux autres bobines composant un autre transducteur pour une mesure de Rogowski.

Dans encore une autre variante dérivée de la Figure 4 et non représentée, quatre bobines 421, 422, 431, 432 peuvent être utilisées pour réaliser un transducteur à Effet Néel^{®} et quatre autres bobines peuvent être utilisées pour réaliser un transducteur de type Rogowski.

Il est possible d'ajouter au mécanisme de fermeture 20 un dispositif de réglage de l'écartement mécanique. Pour cela, le mécanisme de fermeture 20 comporte un système de guidage en translation des extrémités des bobines, ainsi qu'un système de maintien des extrémités des bobines, ledit dispositif de maintien permettant d'en contrôler l'écartement mécanique. Ainsi il est possible de régler la profondeur d'un entrelacement entre les deux boucles selon premier axe d'élongation Y. Le dispositif de réglage peut être basé sur l'utilisation de vis, de cales ou de glissière.

## Revendications

1. Capteur de courant (1, 400), circulant dans un conducteur primaire, réalisant une mesure de circulation d'un champ magnétique généré par le courant circulant dans ledit conducteur primaire, comprenant :
• deux transducteurs magnétiques (2, 3, 42, 43), chaque transducteur magnétique (2, 3, 42, 43) comprenant au moins une bobine allongée (5, 6, 421, 422, 431, 432) s'étendant autour d'un support souple, ledit transducteur magnétique (2, 3, 42, 43) formant une boucle entourant le conducteur primaire ;
• au moins un mécanisme de fermeture (20) des boucles des transducteurs magnétiques (2, 3, 42, 43) permettant de maintenir deux extrémités de bobines allongées (5, 6, 421, 422, 431, 432) d'un transducteur magnétique (2, 3, 42, 43) ;
**caractérisé en ce que** le mécanisme de fermeture (20) assure :
- un écartement mécanique (23, 33) inférieur ou égal à zéro entre les deux extrémités de bobines allongées (5, 6, 421, 422, 431, 432) fermant chaque boucle, selon un premier axe d'élongation Y des bobines (5, 6, 421, 422, 431, 432), ledit axe d'élongation Y étant sensiblement tangent auxdites extrémités ;
- un désaxage de chaque extrémité de bobine (5, 6, 421, 422, 431, 432) d'une boucle par rapport à l'autre extrémité de bobine de la boucle, suivant un axe de désaxage X différent du premier axe d'élongation Y ;
- une inversion mécanique des désaxages entre les boucles.

2. Capteur selon revendication précédente, **caractérisé en ce que** l'écartement mécanique entre les deux extrémités fermant une boucle est inférieur à cinq fois le diamètre moyen des spires de la bobine.

3. Capteur selon l'une quelconque des revendications précédentes, **caractérisé en ce que** l'axe de désaxage X est sensiblement perpendiculaire au premier axe d'élongation Y.

4. Capteur selon la revendication 3, **caractérisé en ce que** l'écartement mécanique entre deux extrémités fermant une boucle, selon l'axe de désaxage X, est sensiblement égal aux écartements mécaniques d'au moins deux autres extrémités fermant une autre boucle du capteur (1, 400).

5. Capteur selon l'une quelconque des revendications précédentes, **caractérisé en ce que** le mécanisme de fermeture (20) est un mécanisme ouvrant comprenant un système de fixation réversible.

6. Capteur selon l'une quelconque des revendications précédentes, **caractérisé en ce que** chaque transducteur (42, 43) comprend deux bobines (421, 422, 431, 432) formant une boucle ouverte.

7. Capteur selon la revendication 6, **caractérisé en ce que** chaque boucle comprenant quatre extrémités de bobine, deux extrémités de bobine (421, 422, 431, 432) d'une même boucle sont assemblées par le mécanisme de fermeture (20) et les deux autres extrémités des bobines (421, 422, 431, 432) sont assemblées pour former une connexion avec un dispositif électronique (44) du capteur (400).

8. Capteur selon l'une quelconque des revendications précédentes, **caractérisé en ce que** le capteur (1, 400) comprend au moins un transducteur (5, 6, 421, 422, 431, 432) apte à mesurer un courant continu.

9. Capteur selon l'une quelconque des revendications précédentes, **caractérisé en ce que** le capteur (1, 400) comprend au moins un transducteur (5, 6, 421, 422, 431, 432) apte à mesurer un courant alternatif.

10. Capteur selon l'une quelconque des revendications précédentes, **caractérisé en ce qu'**un desdits transducteurs (5, 6, 421, 422, 431, 432) est un transducteur à Effet Néel.

11. Capteur selon la revendication précédente, **caractérisé en ce que** le support allongé est un noyau magnétique sensiblement plein, constitué par un matériau magnétique souple comprenant une matrice dans laquelle sont dispersées des particules magnétiques.

12. Capteur selon l'une quelconque des revendications précédente, **caractérisé en ce que** le mécanisme de fermeture (20) comporte un dispositif de réglage de l'écartement mécanique.

13. Capteur selon l'une quelconque des revendications 9 à 12*,* **caractérisé en ce que** le capteur (400) comprend au moins deux bobines (421, 422) aptes à mesurer un courant continu et au moins deux bobines (431, 432) aptes à mesurer un courant alternatif.

14. Capteur selon la revendication précédente, **caractérisé en ce que** le capteur comprend au moins quatre bobines aptes à mesurer un courant continu.

## Patentansprüche

1. Sensor (1, 400) für Strom, der in einem Primärleiter fließt, der eine Flussmessung eines Magnetfeld durchführt, das durch den in dem Primärleiter fließenden Strom erzeugt wird, umfassend:
- zwei Magnetwandler (2, 3, 42, 43), wobei jeder Magnetwandler (2, 3, 42, 43) mindestens eine längliche Spule (5, 6, 421, 422, 431, 432) umfasst, die sich um einen nachgiebigen Träger herum erstreckt, wobei der Magnetwandler (2, 3, 42, 43) eine Schleife bildet, die den Primärleiter umgibt;
- mindestens einen Verschlussmechanismus (20) für die Schleifen der Magnetwandler (2, 3, 42, 43), der erlaubt, zwei Enden von länglichen Spulen (5, 6, 421, 422, 431, 432) eines Magnetwandlers (2, 3, 42, 43) zu halten;
**dadurch gekennzeichnet, dass** der Verschlussmechanismus (20) sicherstellt:
- eine mechanische Beabstandung (23, 33) kleiner als oder gleich null zwischen den zwei Enden von länglichen Spulen (5, 6, 421, 422, 431, 432), die jede Schleife schließen, nach einer ersten Elongationsachse Y der Spulen (5, 6, 421, 422, 431, 432), wobei die Elongationsachse Y zu den Enden im Wesentlichen tangential ist;
- einen Versatz von jedem Ende der Spule (5, 6, 421, 422, 431, 432) einer Schleife bezüglich des anderen Endes der Spule der Schleife entlang einer Versatzachse X, die sich von der ersten Elongationsachse Y unterscheidet;
- eine mechanische Inversion des Versatzes zwischen den Schleifen.

2. Sensor nach vorstehendem Anspruch, **dadurch gekennzeichnet, dass** die mechanische Beabstandung zwischen den zwei Enden, die eine Schleife schließen, kleiner ist als fünfmal der mittlere Durchmesser der Wicklungen der Spule.

3. Sensor nach einem der vorstehenden Ansprüche, **dadurch gekennzeichnet, dass** die Versatzachse X im Wesentlichen senkrecht zu der ersten Elongationsachse Y vorliegt.

4. Sensor nach Anspruch 3, **dadurch gekennzeichnet, dass** die mechanische Beabstandung zwischen zwei Enden, die eine Schleife schließen, nach der Versatzachse X im Wesentlichen gleich den mechanischen Beabstandungen von mindestens zwei anderen Enden ist, die eine andere Schleife des Sensors (1, 400) schließen.

5. Sensor nach einem der vorstehenden Ansprüche, **dadurch gekennzeichnet, dass** der Verschlussmechanismus (20) ein Öffnungsmechanismus ist, umfassend ein System zur reversiblen Befestigung.

6. Sensor nach einem der vorstehenden Ansprüche, **dadurch gekennzeichnet, dass** jeder Wandler (42, 43) zwei Spulen (421, 422, 431, 432) umfasst, die eine offene Schleife bilden.

7. Sensor nach Anspruch 6, **dadurch gekennzeichnet, dass** jede Schleife vier Spulenenden umfasst, wobei zwei Spulenenden (421, 422, 431, 432) einer gleichen Schleife durch den Verschlussmechanismus (20) zusammengefügt sind und die zwei anderen Spulenenden (421, 422, 431, 432) zusammengefügt sind, um eine Verbindung mit einer elektronischen Vorrichtung (44) des Sensors (400) zu bilden.

8. Sensor nach einem der vorstehenden Ansprüche, **dadurch gekennzeichnet, dass** der Sensor (1, 400) mindestens einen Wandler (5, 6, 421, 422, 431, 432) umfasst, der geeignet ist, einen Gleichstrom zu messen.

9. Sensor nach einem der vorstehenden Ansprüche, **dadurch gekennzeichnet, dass** der Sensor (1, 400) mindestens einen Wandler (5, 6, 421, 422, 431, 432) umfasst, der geeignet ist, einen Wechselstrom zu messen.

10. Sensor nach einem der vorstehenden Ansprüche, **dadurch gekennzeichnet, dass** einer der Wandler (5, 6, 421, 422, 431, 432) ein Néel-Effekt-Wandler ist.

11. Sensor nach dem vorstehenden Anspruch, **dadurch gekennzeichnet, dass** der längliche Träger ein im Wesentlichen massiver Magnetkern ist, konstituiert aus einem nachgiebigen magnetischen Material, umfassend eine Matrix, in der magnetische Partikel dispergiert sind.

12. Sensor nach einem der vorstehenden Ansprüche, **dadurch gekennzeichnet, dass** der Verschlussmechanismus (20) eine Justiervorrichtung der mechanischen Beabstandung beinhaltet.

13. Sensor nach einem der Ansprüche 9 bis 12, **dadurch gekennzeichnet, dass** der Sensor (400) mindestens zwei Spulen (421, 422), die geeignet sind, einen Gleichstrom zu messen, und mindestens zwei Spulen (431, 432), die geeignet sind, einen Wechselstrom zu messen, umfasst.

14. Sensor nach dem vorstehenden Anspruch, **dadurch gekennzeichnet, dass** der Sensor mindestens vier Spulen umfasst, die geeignet sind, einen Gleichstrom zu messen.

## Claims

1. Sensor (1, 400) for current flowing in a primary conductor, carrying out a measurement of the circulation of a magnetic field generated by the current flowing in said primary conductor, comprising:
• two magnetic transducers (2, 3, 42, 43), each magnetic transducer (2, 3, 42, 43) comprising at least one elongate coil (5, 6, 421, 422, 431, 432) extending around a flexible support, said magnetic transducer (2, 3, 42, 43) forming a loop surrounding the primary conductor;
• at least one closure mechanism (200) for the loops of the magnetic transducers (2, 3, 42, 43) making it possible to hold two ends of elongate coils (5, 6, 421, 422, 431, 432) of a magnetic transducer (2, 3, 42, 43),
while **characterized in that** the closure mechanism (200) ensures:
- a mechanical gap (23, 33) less than or equal to zero between the two ends of elongate coils (5, 6, 421, 422, 431, 432) closing each loop, along a first elongation axis Y of the coils (5, 6, 421, 422, 431, 432), said elongation axis Y being substantially tangent to said ends;
- an offset of each end of coil (5, 6, 421, 422, 431, 432) of a loop with respect to the other end of coil of the loop, along an offset axis X different from the first elongation axis Y;
- a mechanical inversion of the offsets between the loops.

2. Sensor according to claim 1, **characterized in that** the mechanical gap between the two ends closing a loop is less than five times the average diameter of the turns of the coil.

3. Sensor according to any of the preceding claims, wherein the offset axis X is substantially perpendicular to the first elongation axis Y.

4. Sensor according to claim 43, **characterized in that** the mechanical gap between two ends closing a loop, along the offset axis X, is substantially equal to the mechanical gaps of at least two other ends closing another loop of the sensor (1, 400).

5. Sensor according to any of the preceding claims, **characterized in that** the closure mechanism (20) is an opening mechanism comprising a reversible fastening system.

6. Sensor according to any of the preceding claims, **characterized in that** each transducer (42, 43) comprises two coils (421, 422, 431, 432) forming an open loop.

7. Sensor according to claim 6, **characterized in that** each loop comprising four coil ends, two coil ends (421, 422, 431, 432) of one and the same loop are assembled by the closure mechanism (20) and the other two ends of the coils (421, 422, 431, 432) are assembled to form a connection with an electronic device (44) of the sensor (400).

8. Sensor according to any of the preceding claims, characterized int that the sensor (1, 400) comprises at least one transducer (5, 6, 421, 422, 431, 432) suitable for measuring a direct current.

9. Sensor according to any of the preceding claims, **characterized in that** the sensor (1, 400) comprises at least one transducer (5, 6, 421, 422, 431, 432) suitable for measuring an alternating current.

10. Sensor according to any of the preceding claims, **characterized in that** one of said transducers (5, 6, 421, 422, 431, 432) is a Neel Effect transducer.

11. Sensor according to the preceding claim, **characterized in that** the elongate support is a substantially solid magnetic core, constituted by a flexible magnetic material comprising a matrix in which magnetic particles are dispersed.

12. Sensor according to any of the preceding claims, **characterized in that** the closure mechanism (20) comprises a device for adjusting the mechanical gap.

13. Sensor according to any of claims 9 to 12, **characterized in that** the sensor (400) comprises at least two coils (421, 422) suitable for measuring a direct current and at least two coils (431, 432) suitable for measuring an alternating current.

14. Sensor according to the preceding claim, **characterized in that** the sensor comprises at least four coils suitable for measuring a direct current.
